# EUROPEAN PATENT APPLICATION

(11) **EP 4 492 130 A1**
(43) Date of publication of application: **15.01.2025**
(21) Application number: 23803265.0
(22) Date of filing: 28.03.2023
(51) Int. Cl.: G02F 1/01, G02B 26/08, H01S 5/06, H01S 5/14

(54) **LIGHT SOURCE DEVICE AND CONTROL METHOD**

(30) Priority: 12.05.2022 JP 2022078928
(71) Applicant: Hamamatsu Photonics K.K., Hamamatsu-shi, Shizuoka 435-8558 (JP)
(72) Inventor: KATO Naoaki, Hamamatsu-shi, Shizuoka 435-8558 (JP); TAKIGUCHI Yuu, Hamamatsu-shi, Shizuoka 435-8558 (JP); TANAKA Hiroshi, Hamamatsu-shi, Shizuoka 435-8558 (JP); OHTAKE Yoshiyuki, Hamamatsu-shi, Shizuoka 435-8558 (JP)
(74) Representative: Grünecker Patent- und Rechtsanwälte PartG mbB
(86) International application number: PCT/JP2023/012562
(87) International publication number: WO 2023/218782

(57) **Abstract**

A light source apparatus includes: a light source configured to output light; a reflection unit (spatial light modulator) having an input unit of a control signal and configured to be able to control distribution of angles at which incident light is reflected based on the control signal; and a diffraction grating configured to disperse the light output from the light source, cause the light to be incident on the spatial light modulator, and return at least a part of the light reflected by the spatial light modulator to the light source. An optical cavity is formed by the light source and the spatial light modulator, and a bandwidth of the light returned from the diffraction grating to the light source is controlled by controlling the distribution of angles of the light reflected by the spatial light modulator based on the control signal.

## Description

### Technical Field

One aspect of the present invention relates to a light source apparatus and a control method.

### Background Art

Patent Literature 1 describes a Littman/Metcalf type external cavity semiconductor laser. The external cavity semiconductor laser of Patent Literature 1 is configured to obtain a wide spectrum (bandwidth) by changing an end mirror to a concave mirror and making a radius of curvature (RoC) thereof equal to a distance between the concave mirror and a diffraction grating.

### Citation List

### Patent Literature

Patent Literature 1: Specification of US Patent No. 7245642

### Summary of Invention

### Technical Problem

In the external cavity semiconductor laser as described above, the RoC of the concave mirror is a fixed value. In such a configuration, a bandwidth of light returned from the diffraction grating to a light source cannot be arbitrarily adjusted.

An aspect of the present invention has been made in view of the above circumstances, and provides a light source apparatus and a control method capable of arbitrarily adjusting a bandwidth of light returned from a diffraction grating to a light source.

### Solution to Problem

(1) A light source apparatus according to one aspect of the present invention includes: a light source configured to output light; a reflection unit having an input unit of a control signal and configured to be able to control distribution of angles at which incident light is reflected based on the control signal; and a diffraction grating configured to disperse the light output from the light source and cause the light to be incident on the reflection unit, and return at least a part of the light reflected by the reflection unit to the light source, an optical cavity is formed by the light source and the reflection unit, and the light returned to the light source is output, and a bandwidth of the light returned from the diffraction grating to the light source is controlled by controlling the distribution of angles of the light reflected by the reflection unit based on the control signal.
   In the light source apparatus according to one aspect of the present invention, the light output from the light source is dispersed by the diffraction grating and incident on the reflection unit. Then, at least a part of the light reflected by the reflection unit is returned from the diffraction grating to the light source. In such a light source apparatus, the reflection unit is configured to be able to control the distribution of angles at which the light is reflected based on the control signal, and the bandwidth of the light returned from the diffraction grating to the light source is controlled by controlling the distribution of angles. According to such a configuration, by changing the control signal, the distribution of angles at which the light is reflected by the reflection unit is changed, and the bandwidth of the light returned from the diffraction grating to the light source can be changed. That is, according to the light source apparatus according to one aspect of the present invention, the bandwidth of the light returned from the diffraction grating to the light source can be arbitrarily adjusted.
(2) In the light source apparatus according to (1), the reflection unit may include a spatial light modulator, and the spatial light modulator may control the distribution of angles at which the incident light is reflected by displaying a modulation pattern based on the control signal. As described above, by using the spatial light modulator as the reflection unit, the bandwidth of the light returned from the diffraction grating to the light source can be adjusted easily and with high accuracy.
(3) In the light source apparatus according to (1), the reflection unit may include a variable curvature mirror, and the variable curvature mirror may control the distribution of angles at which the incident light is reflected by changing a RoC based on the control signal. As described above, by changing the RoC using the variable curvature mirror, the bandwidth of the light returned from the diffraction grating to the light source can be appropriately adjusted. In addition, in the variable curvature mirror, it is not necessary to consider an influence of polarization or unmodulated light as compared with a case where distribution of reflection angles is controlled by a modulation pattern such as a spatial light modulator, and thus, it is possible to easily adjust the bandwidth of light.
(4) In the light source apparatus according to (1), the reflection unit may include a mirror and a variable focus lens provided between the diffraction grating and the mirror, and the variable focus lens may control the distribution of angles at which the incident light is reflected by changing a focal length of the variable focus lens based on the control signal. As described above, by changing the focal length of the variable focus lens by using the variable focus lens, the bandwidth of the light returned from the diffraction grating to the light source can be appropriately adjusted. In addition, in such a configuration, it is not necessary to consider the influence of polarization or unmodulated light (it does not need to be considered unless an element sensitive to polarization of light such as liquid crystal is used) as compared with a case where the distribution of reflection angles is controlled by a modulation pattern such as a spatial light modulator, and thus, it is possible to easily adjust the bandwidth of light.
(5) In the light source apparatus according to (1) to (4), the light source may output light according to an injection current, and the bandwidth of the light returned from the diffraction grating to the light source may be dynamically controlled by temporally changing the injection current and the control signal. According to such a configuration, the bandwidth of light can be more flexibly adjusted according to a use scene.
(6) In the light source apparatus according to (1) to (5), the reflection unit and the diffraction grating may be disposed such that a curvature center related to a reflecting surface of the reflection unit coincides with a beam center of the light incident on the diffraction grating. According to such a configuration, paths of light before and after reflection on the reflecting surface of the reflection unit tend to be the same, and the bandwidth of the light returned from the diffraction grating to the light source can be widened.
(7) The light source apparatus according to (1) to (6) may further include a control signal generation unit configured to generate a second control signal based on a measurement result of the light output from the light source apparatus. As described above, by measuring the light returned from the diffraction grating to the light source, feeding back the measurement result, and generating a new control signal (second control signal), the bandwidth of the light can be easily adjusted to a desired value in consideration of an actual measurement result.
(8) A control method according to one aspect of the present invention includes: outputting light from a light source toward a diffraction grating; and inputting a control signal for controlling distribution of angles of light reflected by a reflection unit where light dispersed by the diffraction grating is incident. According to such a control method, the bandwidth of the light returned from the diffraction grating to the light source can be arbitrarily adjusted.
(9) In the light source apparatus according to (1) to (4), a light source unit including the light source may include an excitation light source that outputs excitation light, and a gain fiber that is an optical fiber having a gain corresponding to the excitation light. According to such a configuration, switching between laser oscillation and amplified spontaneous emission can be performed by adjusting power of the excitation light. In addition, by using the gain fiber having the gain corresponding to the excitation light in the light source unit, light is confined in the gain fiber which is a narrow space, and a non-linear effect is likely to occur. Such a non-linear effect is more likely to occur by using a highly non-linear fiber as the gain fiber. Examples of the non-linear effect include self-phase modulation, cross-phase modulation, modulation instability, stimulated Raman scattering, stimulated Brillouin scattering, four-wave mixing, supercontinuum generation, and the like. By using these non-linear effects, a degree of freedom of spectrum control of light is improved, for example, by further expanding the spectrum.
(10) The light source apparatus according to (1) to (7) or (9) may further include an optical fiber configured to guide the light output from the diffraction grating. As described above, according to the configuration in which the light output from the diffraction grating is guided by the optical fiber, the light is confined in the optical fiber, and the non-linear effect is likely to occur. Such a non-linear effect is more likely to occur by using a highly non-linear fiber as the optical fiber. By using the non-linear effect, a degree of freedom of spectrum control of light is improved, for example, by further expanding the spectrum.

### Advantageous Effects of Invention

According to one aspect of the present invention, a bandwidth of light returned from a diffraction grating to a light source can be arbitrarily adjusted.

### Brief Description of Drawings

FIG. 1 is a diagram schematically illustrating a light source apparatus according to a first embodiment.
FIG. 2 is a diagram illustrating an example of a modulation pattern displayed on a spatial light modulator.
FIG. 3 is a diagram illustrating a first operation example of the light source apparatus.
FIG. 4 is a diagram illustrating a second operation example of the light source apparatus.
FIG. 5 is a diagram illustrating a third operation example of the light source apparatus.
FIG. 6 is a diagram illustrating a fourth operation example of the light source apparatus.
FIG. 7 is a diagram schematically illustrating a light source apparatus according to a second embodiment.
FIG. 8 is a diagram schematically illustrating a light source apparatus according to a fourth embodiment.
FIG. 9 is a diagram schematically illustrating a light source apparatus according to a fifth embodiment.
FIG. 10 is a diagram schematically illustrating a light source apparatus according to a sixth embodiment.
FIG. 11 is a diagram illustrating interference measurement using the light source apparatus illustrated in FIG. 10.
FIG. 12 is a flowchart of the interference measurement using the light source apparatus illustrated in FIG. 10.
FIG. 13 is a diagram illustrating interference measurement using a light source apparatus according to a seventh embodiment.
FIG. 14 is a diagram schematically illustrating a light source apparatus according to an eighth embodiment.
FIG. 15 is a diagram schematically illustrating a light source apparatus according to a ninth embodiment.

### Description of Embodiments

Hereinafter, embodiments of the present invention will be described in detail with reference to the drawings. In the drawings, the same or corresponding parts are denoted by the same reference signs, and redundant description will be omitted.

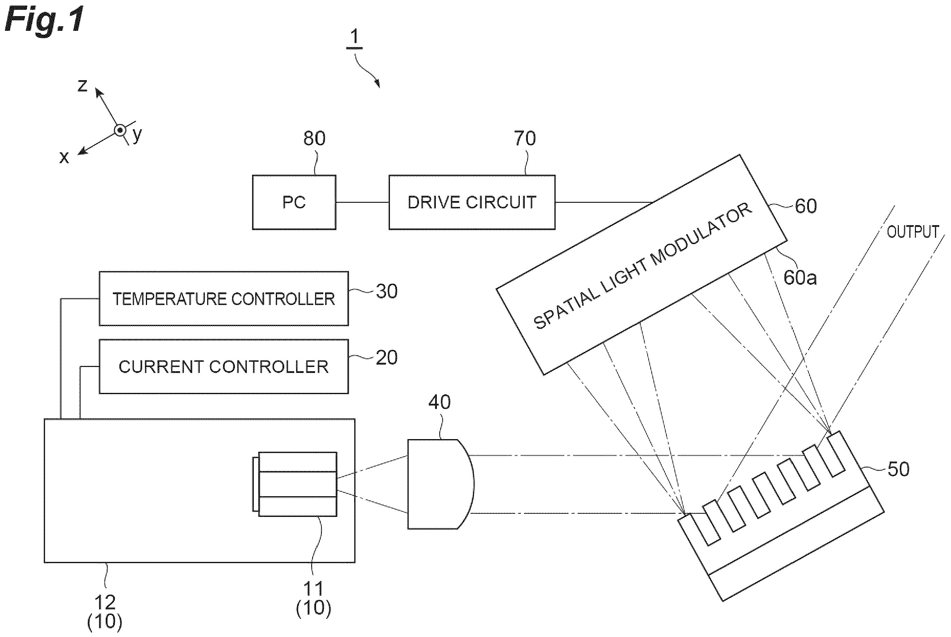

FIG. 1 is a diagram schematically illustrating a light source apparatus 1 according to a first embodiment. The light source apparatus 1 is an external cavity laser (ECL). The light source apparatus 1 is, for example, a Litmann-type external cavity laser, and is configured to reflect +1-order light of a diffraction grating by a mirror and return the light into a semiconductor laser.

As illustrated in FIG. 1, the light source apparatus 1 includes a light source unit 10, a current controller 20, a temperature controller 30, a lens 40, a diffraction grating 50, a spatial light modulator 60 (reflection unit), a drive circuit 70, and a PC 80.

The light source unit 10 includes a light source 11 and an LD mount 12. The light source 11 is, for example, a semiconductor laser (LD: Laser Diode) that outputs light having a spontaneous emission spectrum having a center wavelength of 850 nm. The light source 11 may be, for example, a Fabry-Perot type semiconductor laser. An end surface of the light source 11 on a side coupled to an external cavity (light output direction side) may be provided with an antireflection coating. The light source 11 is mounted on the LD mount 12. The LD mount 12 may be a mount with a thermo-electric cooler (TEC). In the light source apparatus 1, an optical cavity is formed by the light source 11 and the spatial light modulator 60 (described later). In the light source apparatus 1, the light returned to the light source 11 through the external cavity is output.

The current controller 20 is configured to supply a current to the light source 11 via the LD mount 12 to cause the light source 11 to output light. That is, the light source 11 outputs light corresponding to the current (injection current) supplied from the current controller 20. The light source 11 generates laser oscillation or operates at an oscillation threshold or less according to the supplied (injected) current value.

The temperature controller 30 is configured to control heat absorption (or heat dissipation) of the TEC by supplying a current to the TEC provided in the LD mount 12 and to keep a temperature of the light source 11 constant via the TEC.

The lens 40 is a lens (for example, a collimating lens) that efficiently couples the light output from the light source 11 to the light source 11 when the light returns through the diffraction grating 50 and the spatial light modulator 60 (after one round trip in the external cavity). When the light emitted from the light source 11 spreads greatly, a beam diameter and a divergence angle of the light are adjusted by the lens 40. Note that the light transmitted through the lens 40 may be collimated light or may not be collimated light. A position of the lens 40 may be fixed at a position where a high light output can be obtained regardless of a focal length of a modulation pattern (phase pattern) displayed on the spatial light modulator 60.

The diffraction grating 50 is configured to disperse light having various wavelengths and output from the light source 11 to cause the light to be incident on the spatial light modulator 60, and return at least a part of the light reflected by the spatial light modulator 60 to the light source 11. In the diffraction grating 50, light is divided for each wavelength, and +1-order light is directed to the spatial light modulator 60 and 0th order light is extracted as output light.

The spatial light modulator 60 controls the distribution of angles at which the incident light is reflected by displaying the modulation pattern based on a control signal (described later). The spatial light modulator 60 is, for example, a spatial light modulator (SLM) of a reflective liquid crystal on silicon (LCOS). The modulation pattern (phase pattern) is generated by the PC 80, input from the PC 80 to the drive circuit 70, and displayed on the spatial light modulator 60 based on a control signal from the drive circuit 70. As described above, the control signal input from the drive circuit 70 to the spatial light modulator 60 is a signal related to the display of the modulation pattern.

The spatial light modulator 60 displays, for example, a lens pattern as a modulation pattern. For example, a Fresnel lens pattern may be used as the lens pattern. Hereinafter, in the present embodiment, it is assumed that the lens pattern is a Fresnel lens pattern, but the lens pattern may be an aspherical lens pattern or the like. A RoC of the Fresnel lens pattern is a value obtained by doubling a focal length. The RoC is a positive value in a case of a concave mirror and a negative value in a case of a convex mirror. The focal length is a positive value in a case of a convex lens and a negative value in a case of a concave lens. In the spatial light modulator 60, the focal length of the Fresnel lens pattern as the modulation pattern is changed, so that the RoC of the Fresnel lens pattern is changed, and the distribution of angles of the light reflected by the spatial light modulator 60 is changed. When the distribution of angles of the light reflected by the spatial light modulator 60 changes, a degree of coincidence of paths of light before and after the reflection in the spatial light modulator 60 changes. In the spatial light modulator 60, as the degree of coincidence between the RoC of the Fresnel lens pattern and a distance between the spatial light modulator 60 and the diffraction grating 50 is higher, a wavelength band in which the paths of light before and after the reflection in the spatial light modulator 60 coincide with each other (a wavelength band in which coupling efficiency to the light source 11 is high) becomes wider. As described above, the spatial light modulator 60 can control the bandwidth of the light returned from the diffraction grating 50 to the light source 11 by controlling the distribution of angles of the reflected light based on the control signal. That is, the spatial light modulator 60 can control a spread of an optical spectrum by changing the focal length of the Fresnel lens pattern. As described above, the spatial light modulator 60 can control the spread of the optical spectrum without moving or aligning the optical components. Note that the bandwidth of the light returned to the light source 11 is determined, for example, from a wavelength dependency of the coupling efficiency to the light source 11, an emission spectrum of the light source 11, and the like.

In a case where the spatial light modulator 60 is the spatial light modulator of the reflective liquid crystal on silicon, phase modulation by the spatial light modulator 60 is strongly affected by polarization of light. The spatial light modulator 60 is disposed such that a polarization direction in which the phase modulation can be performed is an x direction or a y direction (that is, a direction parallel to a reflecting surface 60a in the spatial light modulator 60) in FIG. 1. The spatial light modulator 60 may be disposed such that the reflecting surface 60a and the reflecting surface in the diffraction grating 50 are parallel, or may be disposed so as not to be parallel. The polarization direction in which the phase modulation can be performed in the spatial light modulator 60 is made to coincide with, for example, a linear polarization direction of the light output from the light source 11. Furthermore, for the spatial light modulator 60, alignment of an optical system or adjustment of a modulation pattern position may be performed such that a normal extending from a center of the modulation pattern passes through a beam center of the light on the diffraction grating 50. The spatial light modulator 60 and the diffraction grating 50 may be disposed such that a curvature center related to the reflecting surface 60a of the spatial light modulator 60 coincides with the beam center of the light incident on the diffraction grating 50. More specifically, the spatial light modulator 60 and the diffraction grating 50 may be disposed such that a trajectory of the curvature center in a case where a RoC related to the reflecting surface 60a of the spatial light modulator 60 is changed intersects the beam center of the light incident on the diffraction grating 50. The curvature center related to the reflecting surface 60a of the spatial light modulator 60 is the curvature center of the modulation pattern displayed on the spatial light modulator 60.

The spatial light modulator 60 may display a predetermined surface shape correction pattern superimposed on the modulation pattern as necessary. Here, the surface shape correction pattern is a pattern for correcting a shape of the reflecting surface 60a of the spatial light modulator 60. The spatial light modulator 60 may further superimpose and display a pattern for correcting aberration generated in the optical system. In addition, the spatial light modulator 60 may display modulation patterns (Fresnel lens patterns) having different focal lengths in the x direction and the y direction. In this case, for example, by optimizing the focal length in the y direction, the coupling efficiency of the light returned to the light source 11 can be increased. Note that in the spatial light modulator 60, the above-described control of the bandwidth of light (spread control of the optical spectrum) may be performed by changing only the focal length in the x direction.

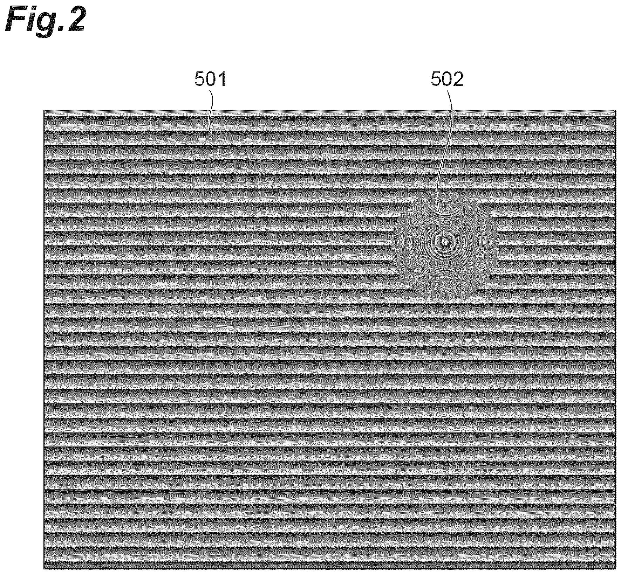

In the spatial light modulator 60, there is a problem that unmodulated light appears as 0th order light. As a countermeasure against such a problem, as illustrated in FIG. 2, a pattern in which a blazed diffraction grating pattern is superimposed on the Fresnel lens pattern may be used as the modulation pattern displayed on the spatial light modulator 60. FIG. 2 illustrates a blazed diffraction grating pattern 501 and a pattern 502 in which the blazed diffraction grating pattern is superimposed on the Fresnel lens pattern. In this case, +1-order light diffracted by the pattern 502 in which the blazed diffraction grating pattern is superimposed on the Fresnel lens pattern may be returned to the light source 11.

Next, first to sixth operation examples will be described as operation examples of the light source apparatus 1.

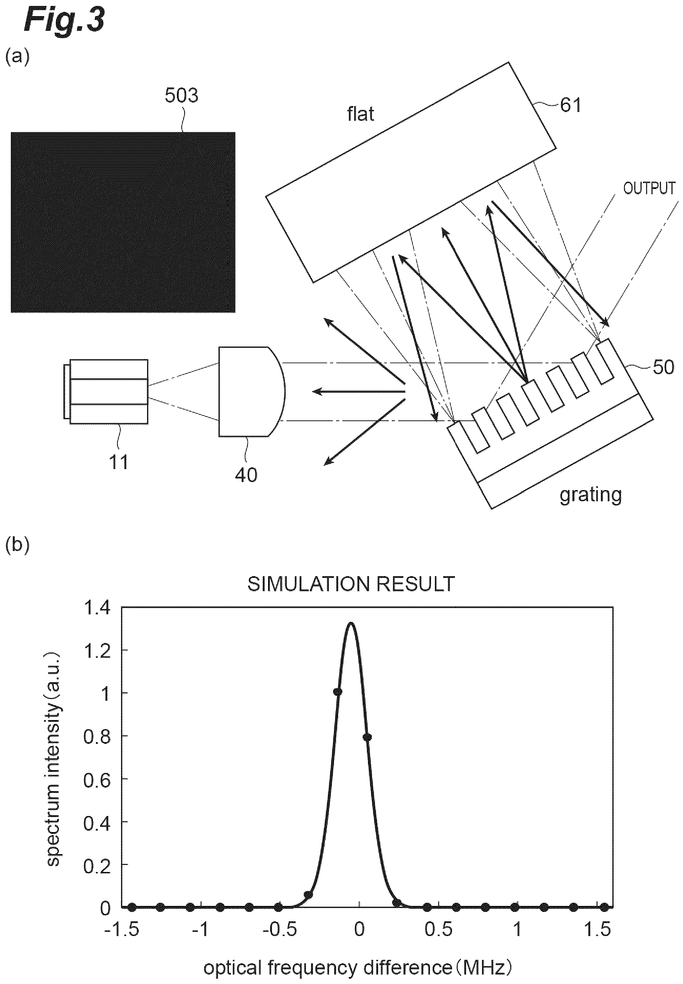

FIG. 3 is a diagram illustrating a first operation example of the light source apparatus 1. As illustrated in FIG. 3(a), in the first operation example, a modulation pattern in which a RoC of the Fresnel lens pattern is ∞ (flat mirror) is displayed in the spatial light modulator 60. In this case, a modulation pattern 503 of a uniform image as illustrated in FIG. 3(a) is displayed. FIG. 3(b) is a simulation result illustrating a bandwidth of the output light of the light source apparatus 1 in a case where the RoC of the Fresnel lens pattern is set to ∞. As illustrated in FIG. 3(b), in a case where the RoC of the Fresnel lens pattern is ∞, a wavelength band in which paths of light before and after reflection in the spatial light modulator 60 coincide with each other (a wavelength band in which coupling efficiency to the light source 11 is high) is narrowed, and in the example of FIG. 3(b), a bandwidth of the light output from the light source apparatus 1 is about 500 kHz. Note that a spread of the oscillation spectrum is determined by a gain frequency characteristic of the light source 11, a non-linear behavior of laser oscillation, a bandwidth of light returned to the light source 11, and the like.

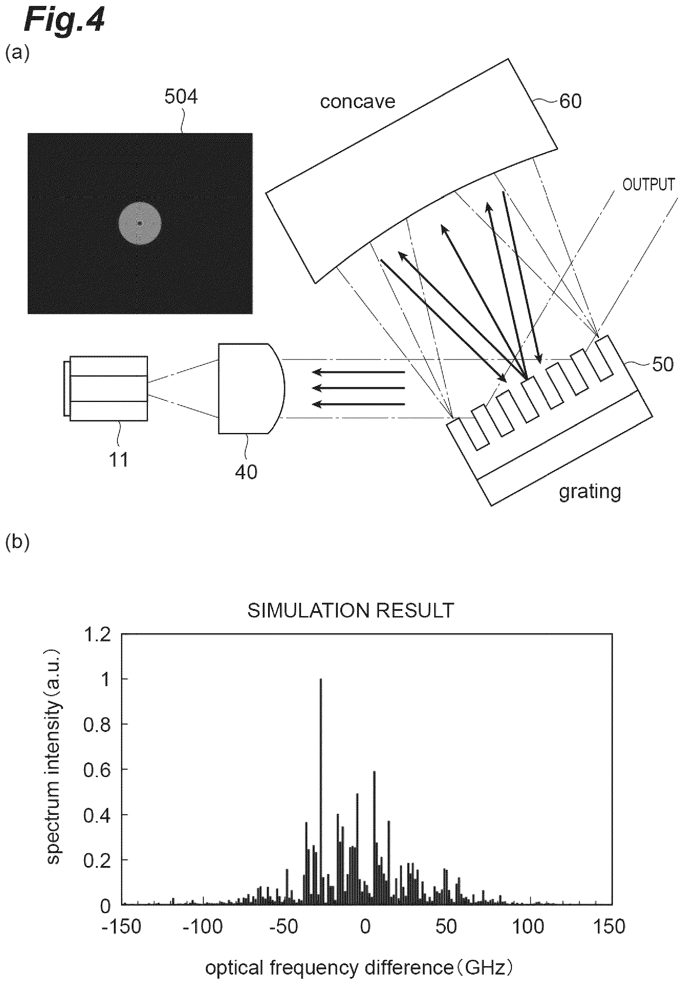

FIG. 4 is a diagram illustrating a second operation example of the light source apparatus 1. In the second operation example illustrated in FIG. 4(a), in the spatial light modulator 60, a modulation pattern in which the RoC of the Fresnel lens pattern is the same as the distance between the spatial light modulator 60 and the diffraction grating 50 is displayed. In this case, as illustrated in FIG. 4(a), for example, a modulation pattern 504 of a convex lens having a focal length of 45 mm is displayed. In the spatial light modulator 60, since the phase modulation only needs to be performed in a region where light strikes, in the modulation pattern 504 illustrated in FIG. 4(a), the Fresnel lens pattern is displayed only in a limited region (center region in the drawing). In a case where the RoC of the Fresnel lens pattern is the same as the distance between the spatial light modulator 60 and the diffraction grating 50, since the light beam spreads from the curvature center, all the wavelength components return to the same path as an original path by reflection at the spatial light modulator 60. That is, the wavelength dependency of the diffraction angle in the diffraction grating 50 is canceled by the spatial light modulator 60. FIG. 4(b) is a simulation result illustrating the bandwidth of the output light of the light source apparatus 1 in a case where the RoC of the Fresnel lens pattern is the same as the distance between the spatial light modulator 60 and the diffraction grating 50. As illustrated in FIG. 4(b), when the RoC of the Fresnel lens pattern is set to be the same as the distance between the spatial light modulator 60 and the diffraction grating 50, the bandwidth of the light returned to the light source 11 is extremely wide.

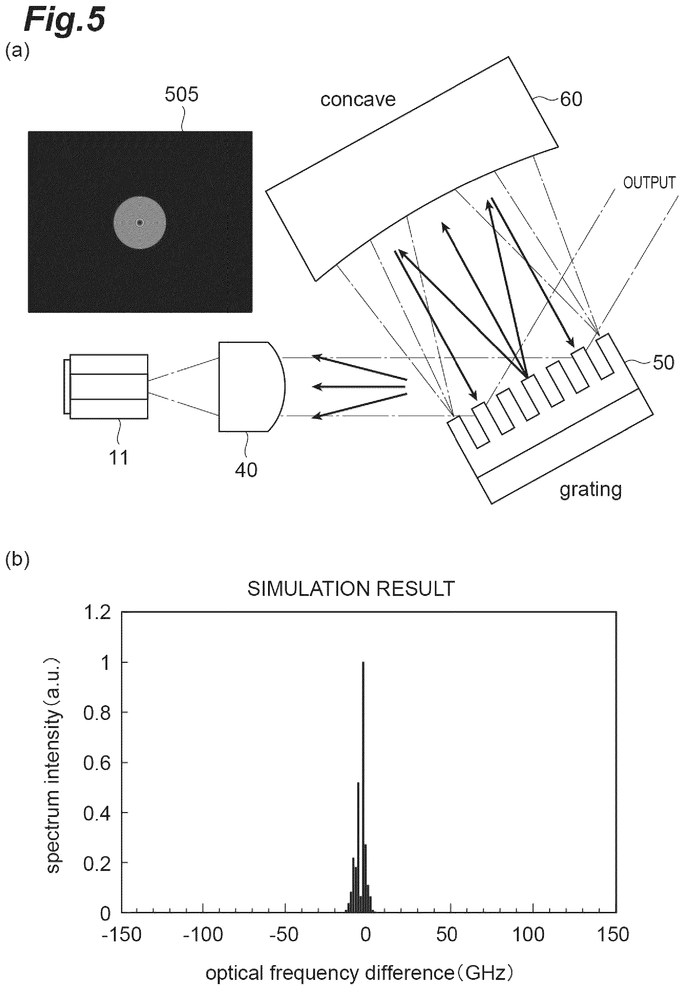

FIG. 5 is a diagram illustrating a third operation example of the light source apparatus 1. In the third operation example illustrated in FIG. 5(a), in the spatial light modulator 60, a modulation pattern in which the RoC of the Fresnel lens pattern is larger than the distance between the spatial light modulator 60 and the diffraction grating 50 is displayed. In this case, as illustrated in FIG. 5(a), for example, a modulation pattern 505 of a convex lens having a focal length of 55 mm is displayed. FIG. 5(b) is a simulation result illustrating the bandwidth of the output light of the light source apparatus 1 in a case where the RoC of the Fresnel lens pattern is made larger than the distance between the spatial light modulator 60 and the diffraction grating 50. As illustrated in FIG. 5(b), in a case where the RoC of the Fresnel lens pattern is made larger than the distance between the spatial light modulator 60 and the diffraction grating 50, the bandwidth of the light returned to the light source 11 is wider than that in the first operation example and narrower than that in the second operation example. That is, an intermediately wide spectrum between the first operation example and the second operation example is obtained.

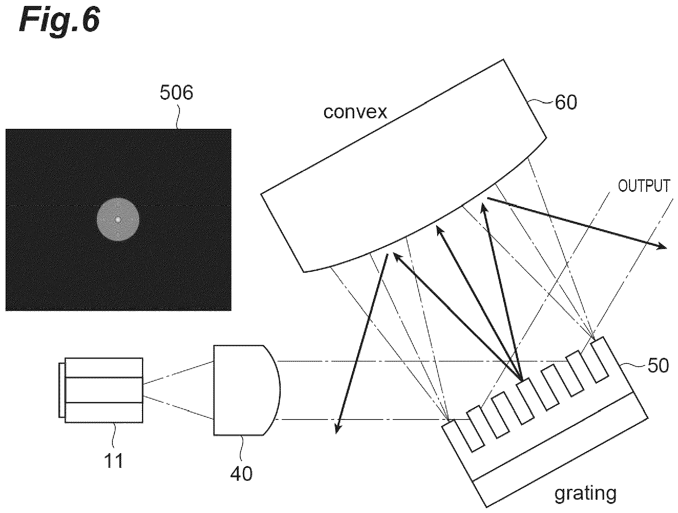

FIG. 6 is a diagram illustrating a fourth operation example of the light source apparatus 1. In the fourth operation example illustrated in FIG. 6(a), a modulation pattern of a convex curved mirror (convex mirror) is displayed in the spatial light modulator 60. In this case, as illustrated in FIG. 6(a), for example, a modulation pattern 506 of a concave lens having a focal length of 45 mm is displayed. In a case where such a modulation pattern is displayed, a difference in a diffraction angle for each wavelength by the diffraction grating is increased by the convex mirror, so that a wavelength band in which the light source 11 can be straightly returned is narrowed, and a narrower bandwidth than that in the case where the RoC is ∞ as in the first operation example can be realized. The smaller an absolute value of the RoC of the convex mirror, the smaller a width of the wavelength dependency of the coupling efficiency. Note that in a case where a beam diameter of each wavelength is sufficiently small on the reflecting surface (in a case where a beam diameter is about several pixels), the bandwidth of light can be further narrowed by reducing an intensity of the 0th order light by displaying a diffraction grating pattern in a column other than a column corresponding to a center wavelength (series of pixels in the y direction). A direction of the diffraction grating pattern is, for example, a direction in which light is diffracted in the y direction. The number of columns corresponding to the center wavelength may be plural.

A fifth operation example of the light source apparatus 1 will be described. In the fifth operation example, the injection current supplied from the current controller 20 to the light source 11 is equal to or less than a threshold current. In this case, the light source 11 operates in a region of amplified spontaneous emission (ASE) without generating laser oscillation. Since the ASE is non-polarized light, a linear polarizer may be provided in the optical cavity formed by the light source 11 and the spatial light modulator 60.

A sixth operation example of the light source apparatus 1 will be described. In the sixth operation example, by temporally changing each of the injection current supplied to the light source 11 by the current controller 20 and the control signal supplied to the spatial light modulator 60 by the drive circuit 70, the bandwidth (spread of the optical spectrum) of the light returned from the diffraction grating 50 to the light source 11 is dynamically controlled. Temporally changing the control signal corresponds to, for example, dynamically and continuously switching the modulation pattern and the like in the first operation example to the fourth operation example described above.

Next, functions and effects of the light source apparatus 1 according to the first embodiment will be described.

The light source apparatus 1 includes: a light source 11 configured to output light; a reflection unit (spatial light modulator 60) having an input unit of a control signal and configured to be able to control distribution of angles at which incident light is reflected based on the control signal; and a diffraction grating 50 configured to disperse the light output from the light source 11, cause the light to be incident on the spatial light modulator 60, and return at least a part of the light reflected by the spatial light modulator 60 to the light source. An optical cavity is formed by the light source 11 and the spatial light modulator 60, and the light returned to the light source 11 is output, and a bandwidth of the light returned from the diffraction grating 50 to the light source 11 is controlled by controlling the distribution of angles of the light reflected by the spatial light modulator 60 based on the control signal.

In the light source apparatus 1 according to the present embodiment, the light output from the light source 11 is dispersed by the diffraction grating 50 and incident on the spatial light modulator 60. Then, at least a part of the light reflected by the spatial light modulator 60 is returned from the diffraction grating 50 to the light source 11. In such a light source apparatus 1, the spatial light modulator 60 is configured to be able to control the distribution of angles at which the light is reflected based on the control signal, and the bandwidth of the light returned from the diffraction grating 50 to the light source 11 is controlled by controlling the distribution of angles. According to such a configuration, by changing the control signal, the distribution of angles at which the light is reflected by the spatial light modulator 60 is changed, and the bandwidth of the light returned from the diffraction grating 50 to the light source 11 can be changed. That is, according to the light source apparatus 1 of the present embodiment, the bandwidth of the light returned from the diffraction grating 50 to the light source 11 can be arbitrarily adjusted.

The spatial light modulator 60 may control the distribution of angles at which the incident light is reflected by displaying the modulation pattern based on the control signal. As described above, the bandwidth of the light returned from the diffraction grating 50 to the light source 11 can be adjusted easily and with high accuracy by using the spatial light modulator 60 as the reflection unit.

The light source 11 may output light according to an injection current, and the bandwidth of the light returned from the diffraction grating 50 to the light source 11 may be dynamically controlled, by temporally changing the injection current and the control signal. According to such a configuration, the bandwidth of light can be more flexibly adjusted according to a use scene.

As the use scene here, for example, in a field of optical communication, it is conceivable to evaluate how performance of a coherent communication system or an optical component changes according to a bandwidth of light, what influence is given when the bandwidth of light dynamically changes, and the like. Alternatively, as the use scene, in imaging using coherent light, a case of using the coherent light to reduce temporal coherence so as to reduce speckle noise is considered. Note that the use scene is not limited to the above.

The spatial light modulator 60 and the diffraction grating 50 may be disposed such that the curvature center related to the reflecting surface 60a of the spatial light modulator 60 coincides with the beam center of light incident on the diffraction grating 50. According to such a configuration, paths of light before and after reflection on the reflecting surface 60a of the spatial light modulator 60 tend to be the same, and a bandwidth of light returned from the diffraction grating 50 to the light source 11 can be widened.

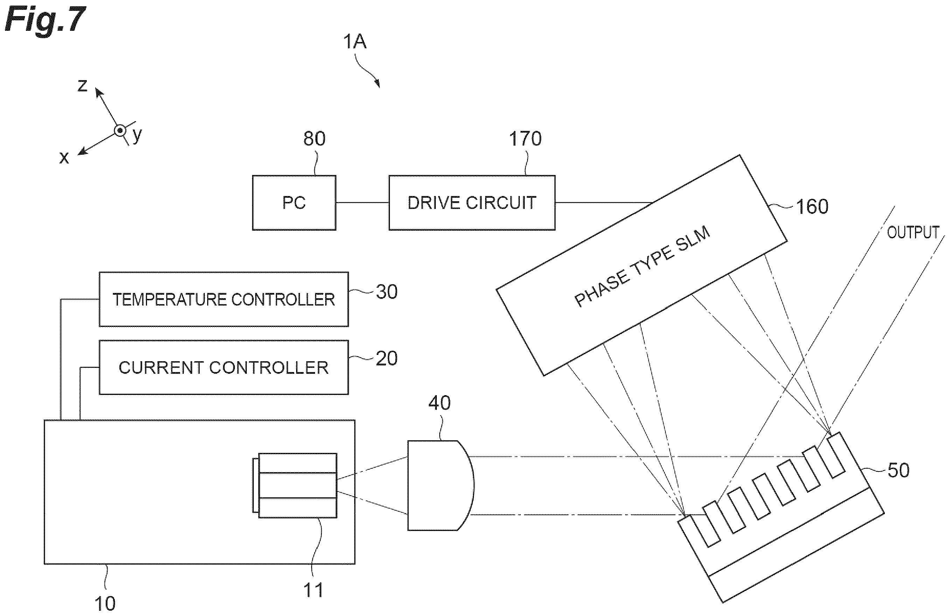

Next, a light source apparatus 1A according to a second embodiment will be described with reference to FIG. 7. FIG. 7 is a diagram schematically illustrating the light source apparatus 1A according to the second embodiment. In the following description, configurations different from those of the light source apparatus 1 according to the first embodiment will be mainly described, and description of configurations common to each other will be omitted (the same applies to the third to seventh embodiments described later).

The light source apparatus 1A illustrated in FIG. 7 includes, as a reflection unit, a phase type SLM 160 using a segmented deformable mirror in which a reflecting surface is structurally separated as a pixel. In such a phase type SLM 160, since a reflection portion of the pixel translates to change an optical path length, a phase modulation is hardly affected by polarization. Also in the case of using the phase type SLM 160, it is similar to the light source apparatus 1 described above in that the distribution of angles at which the incident light is reflected is controlled based on a control signal from a drive circuit 170, thereby controlling a bandwidth of the light returned from the diffraction grating 50 to the light source 11.

Next, a light source apparatus according to a third embodiment will be described. The light source apparatus according to the third embodiment has reflecting surfaces coupled by one continuous film as the reflection unit. Such a reflection unit may include, for example, a continuous deformable mirror. The continuous deformable mirror performs spatial phase modulation by deforming the reflecting surfaces by an actuator array behind the reflecting surfaces. The arrangement of the actuator array of such a phase type SLM may be, for example, a square array or a hexagonal array. In such a phase type SLM, the phase modulation is hardly affected by polarization of light, and generation of unmodulated light as seen in the spatial light modulator having a pixel structure is suppressed. Since the reflecting surfaces are coupled to each other by a continuous film, a pattern in which the phase is wrapped cannot be displayed. Therefore, a lens pattern without phase wrapping may be used as a modulation pattern. When a desired pattern is displayed, it is necessary to determine a control matrix (or an influence function matrix).

In a case where the phase type SLM using the continuous deformable mirror is used as the reflection unit, a layout of the actuator array of the phase type SLM may be, for example, radial. In such a phase type SLM, the phase modulation is hardly affected by polarization of light, and generation of unmodulated light as seen in the spatial light modulator having a pixel structure is suppressed. In the modulation pattern in this case, a pattern center and a device center are the same. When the modulation pattern is operated as, for example, a variable curvature mirror, a lens pattern without phase wrapping may be displayed. When a desired pattern is displayed, it is necessary to determine a control matrix (or an influence function matrix).

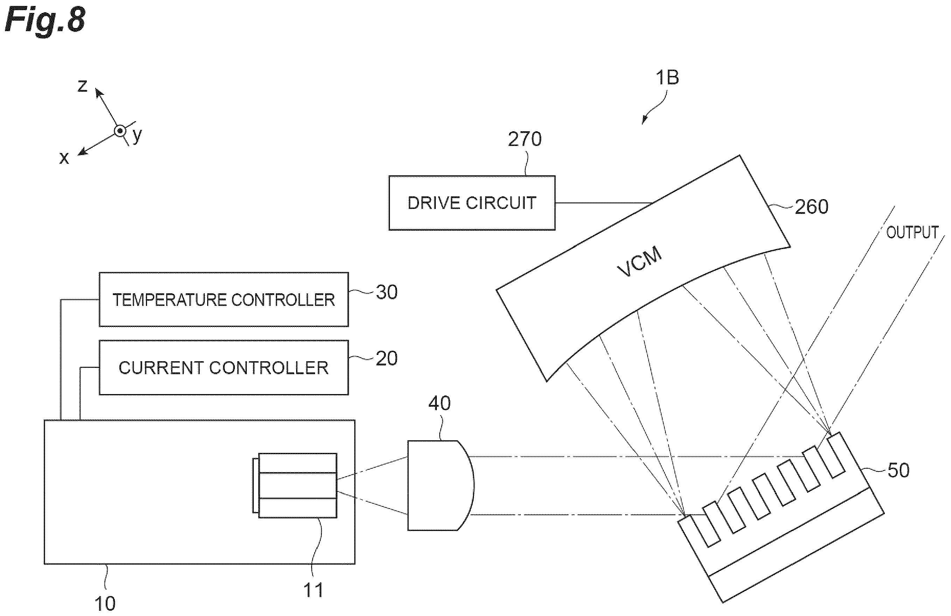

Next, a light source apparatus 1B according to a fourth embodiment will be described with reference to FIG. 8. FIG. 8 is a diagram schematically illustrating the light source apparatus 1B according to the fourth embodiment. As illustrated in FIG. 8, the light source apparatus 1 has a variable curvature mirror (VCM) 260 as a reflection unit. The variable curvature mirror 260 controls distribution of angles at which incident light is reflected, by physically changing a RoC of a reflecting surface based on a control signal from a drive circuit 270. The variable curvature mirror 260 can be changed to both a concave mirror and a convex mirror. As the variable curvature mirror 260, for example, an aspect in which a pressure of a fluid behind a mirror is changed, an aspect in which an actuator behind a mirror is operated, an aspect in which thermal expansion is used, an aspect in which electrostatic force is used, and the like can be considered. Such a variable curvature mirror 260 is hardly affected by polarized light, and generation of unmodulated light as seen in the spatial light modulator having the pixel structure is suppressed.

As described above, the bandwidth of the light returned from the diffraction grating 50 to the light source can be appropriately adjusted by changing the RoC by using the variable curvature mirror 260. In addition, in the variable curvature mirror 260, it is not necessary to consider an influence of polarization or unmodulated light as compared with a case where the distribution of reflection angles is controlled by a modulation pattern such as a spatial light modulator, and thus, it is possible to easily adjust the bandwidth of light.

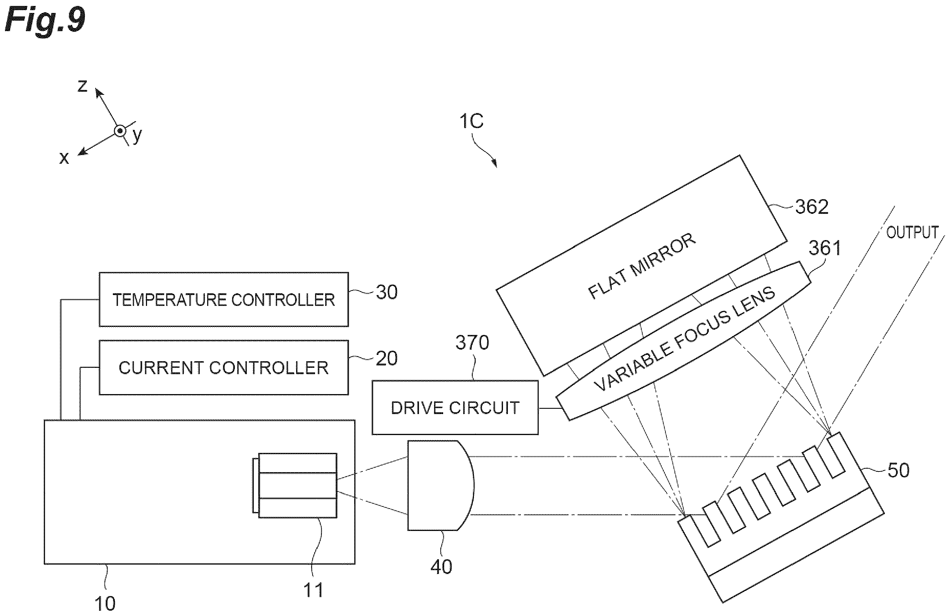

Next, a light source apparatus 1C according to a fifth embodiment will be described with reference to FIG. 9. FIG. 9 is a diagram schematically illustrating the light source apparatus 1C according to the fifth embodiment. As illustrated in FIG. 9, the light source apparatus 1C has a variable focus lens 361 and a flat mirror 362 (mirror) as reflection units. The variable focus lens 361 controls the distribution of angles at which the incident light is reflected by changing a focal length of the variable focus lens 361 based on a control signal from a drive circuit 370. The variable focus lens 361 is provided between the diffraction grating 50 and the flat mirror 362, and may be provided so as to be as close as possible to the flat mirror 362.

In such a configuration, light dispersed by the diffraction grating 50 is incident on the flat mirror 362 through the variable focus lens 361, and light reflected by the flat mirror 362 is returned to the light source 11 through the variable focus lens 361 and the diffraction grating 50. Since the light returned to the light source 11 passes through the variable focus lens 361 twice, an effective focal length and a principal plane are obtained, whereby the focal length and an operation mode (control of the distribution of angles at which the light is reflected) are associated. Such a configuration is applicable to both a concave mirror and a convex mirror. Examples of an aspect of the variable focus lens 361 include a lens that changes a shape of a liquid-sealed object, a lens that uses deformation of a liquid interface, a lens that uses an electro-optical effect, and a lens that uses liquid crystal. In such a configuration, a phase modulation is hardly affected by polarization of light, and is also hardly affected by unmodulated light. However, in a case of using an element sensitive to polarization of light such as liquid crystal, it is necessary to consider the influence of the polarization and the unmodulated light.

As described above, by changing the focal length of the variable focus lens 361 by using the variable focus lens 361, the bandwidth of the light returned from the diffraction grating 50 to the light source 11 can be appropriately adjusted. In addition, in such a configuration, it is not necessary to consider the influence of polarization or unmodulated light (it does not need to be considered unless an element sensitive to polarization of light such as liquid crystal is used) as compared with a case where the distribution of reflection angles is controlled by a modulation pattern such as a spatial light modulator, and thus, it is possible to easily adjust the bandwidth of light.

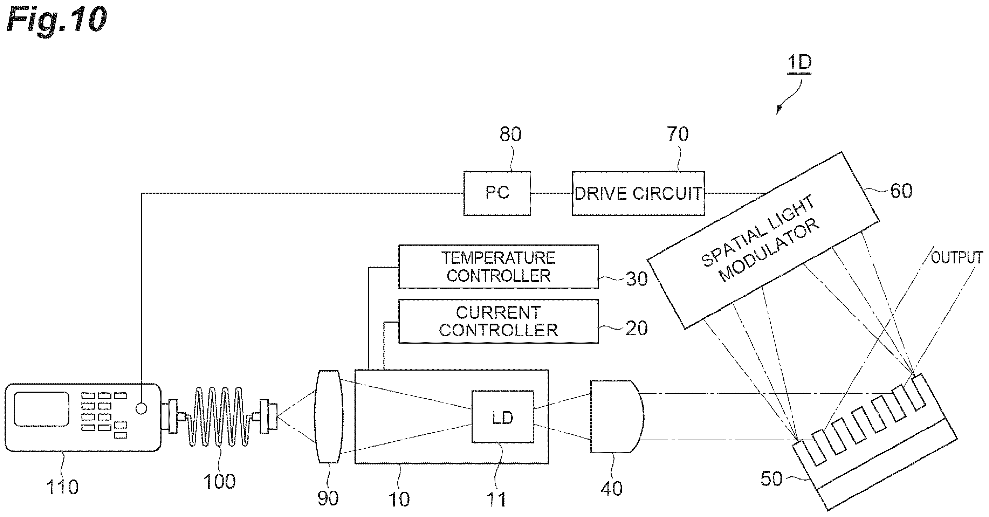

Next, a light source apparatus 1D according to a sixth embodiment will be described with reference to FIG. 10. FIG. 10 is a diagram schematically illustrating the light source apparatus 1D according to the sixth embodiment. The light source apparatus 1D illustrated in FIG. 10 includes an objective lens 90, an optical fiber 100, and a spectrometer (for example, an optical spectrum analyzer) 110 in addition to the configuration of the light source apparatus 1 according to the first embodiment. These additional configurations are for monitoring light from an end surface of the light source 11 that is not coupled to the external cavity.

That is, in the light source apparatus 1D, for example, light from the end surface not coupled to the external cavity is coupled to the optical fiber 100 by the objective lens 90. Then, the light is input to the optical spectrum analyzer 110 via the optical fiber 100. The optical spectrum analyzer 110 measures a spectrum of the input light and outputs a measurement result to the PC 80. Then, the PC 80 generates a modulation pattern to which the measurement result in the optical spectrum analyzer 110 is fed back, and outputs the modulation pattern to the drive circuit 70. The modulation pattern to which the measurement result is fed back is displayed on the spatial light modulator 60 based on a control signal from the drive circuit 70. As described above, in the light source apparatus 1D, based on the measurement result of the light returned from the diffraction grating 50 to the light source 11, a bandwidth of which has been controlled based on an original control signal (first control signal), a new control signal (second control signal) to which the measurement result is fed back is generated. In this case, the optical spectrum analyzer 110, the PC 80, and the drive circuit 70 correspond to a control signal generation unit.

As described above, by measuring the light returned from the diffraction grating 50 to the light source 11, feeding back the measurement result, and generating a new control signal (second control signal), the bandwidth of the light can be easily adjusted to a desired value in consideration of an actual measurement result.

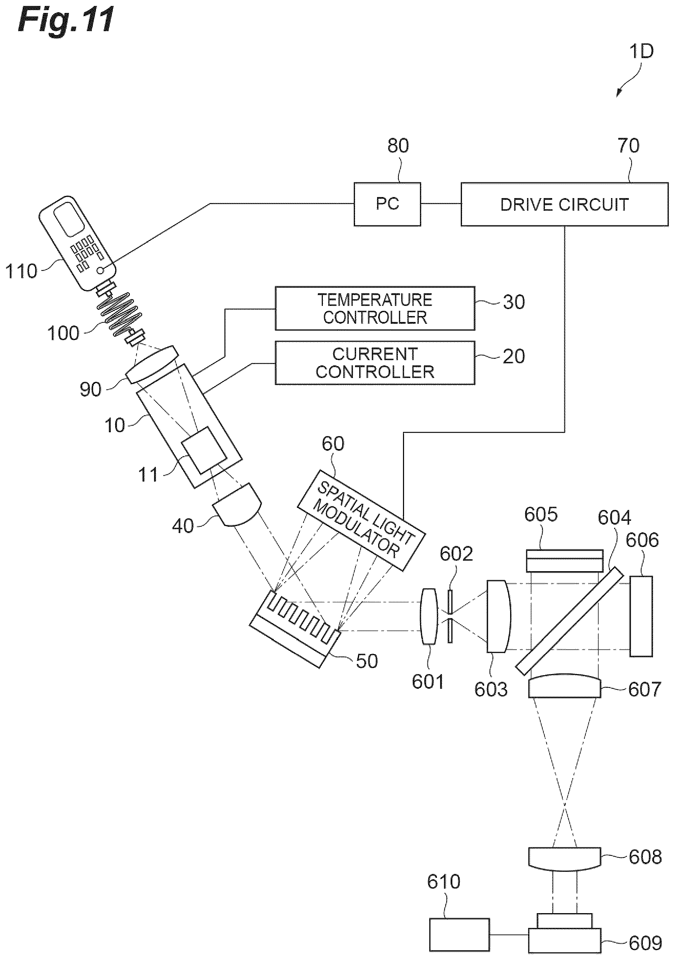

FIG. 11 is a diagram illustrating an example of interference measurement using the light source apparatus 1D illustrated in FIG. 10. In the present interference measurement, interference measurement is performed by using light output from the light source 11 of the light source apparatus 1D. An object-to-be-measured 606 illustrated in FIG. 11 is a measurement object (sample) in the interference measurement. A CMOS camera 609 illustrated in FIG. 11 is a detector in the interference measurement. An objective lens 601, a pinhole 602, a lens 603, a beam splitter 604, a reference mirror 605, a lens 607, and a lens 608 illustrated in FIG. 11 are interferometers in the interference measurement. A PC 610 performs predetermined processing based on an image acquired by the CMOS camera 609.

The light output from the light source 11 reaches the lens 603 through the objective lens 601 and the pinhole 602. The objective lens 601 and the pinhole 602 function as a spatial filter. The light is converted into collimated light by the lens 603. The light converted into the collimated light by the lens 603 reaches the beam splitter 604, and is divided into light that is directly transmitted and reaches the object-to-be-measured 606 and light that is reflected and reaches the reference mirror 605. The light reflected by the object-to-be-measured 606 is reflected by the beam splitter 604, transmitted through the lens 607 and the lens 608 configuring a 4f system, and is detected by the CMOS camera 609. The light from the reference mirror 605 is transmitted through the beam splitter 604, transmitted through the lens 607 and the lens 608, and detected by the CMOS camera 609.

In the interferometer, both an optical path length from the lens 607 to the reference mirror 605 and an optical path length from the lens 607 to the object-to-be-measured 606 coincide with a focal length of the lens 607. Furthermore, an optical path length from the lens 608 to the CMOS camera 609 coincides with a focal length of the lens 608.

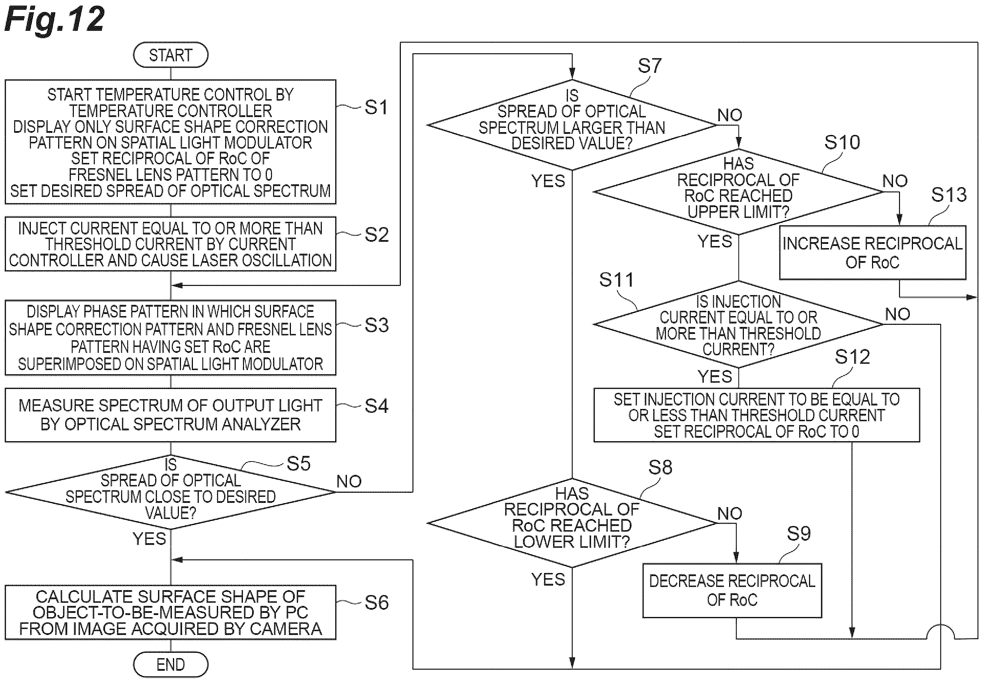

The interference measurement processing using the light source apparatus 1D illustrated in FIG. 10 will be described with reference to FIG. 12. FIG. 12 is a flowchart of the interference measurement using the light source apparatus 1D illustrated in FIG. 11.

As illustrated in FIG. 12, first, preprocessing is performed (step S1). In the preprocessing, the temperature controller 30 starts temperature control of the TEC provided in the LD mount 12. In addition, only a surface shape correction pattern is displayed on the spatial light modulator 60. In addition, a reciprocal of a RoC of a Fresnel lens pattern which is a modulation pattern of the spatial light modulator 60 is set to 0. As described above, when the reciprocal of the RoC is used as a parameter in this manner, handling is facilitated in both cases where the RoC is positive (in a case of a concave mirror) and negative (in a case of a convex mirror), and handling of the RoC: ∞ can be eliminated. In addition, a target value of a spread (bandwidth) of an optical spectrum is set.

Subsequently, the current controller 20 injects a current equal to or more than an oscillation threshold into the light source 11, and causes the light source 11 to generate laser oscillation (step S2). Subsequently, a modulation pattern (phase pattern) in which the surface shape correction pattern and the Fresnel lens pattern having the set RoC are superimposed is displayed on the spatial light modulator 60 (step S3).

Subsequently, a spectrum of light (output light) returned to the light source 11 is measured by the optical spectrum analyzer 110 (step S4). Then, it is determined whether or not the spread (bandwidth) of the optical spectrum is close to a desired value (step S5).

In a case where it is determined in step S5 that the spread of the optical spectrum is close to the desired value, for example, in the PC 610, a surface shape of the object-to-be-measured 606 is calculated from an image acquired by the CMOS camera 609 (step S6).

In a case where it is determined in step S5 that the spread of the optical spectrum is not close to the desired value, it is determined whether or not the spread of the optical spectrum is larger than the desired value (step S7).

In a case where it is determined in step S7 that the spread of the optical spectrum is larger than the desired value, it is determined whether or not the reciprocal of the RoC has reached a lower limit (step S8). The lower limit of the reciprocal of the RoC may be, for example, (-1/distance between the spatial light modulator 60 and the diffraction grating 50). In a case where it is determined in step S8 that the lower limit has been reached, the processing of step S6 is performed. In a case where it is determined in step S8 that the reciprocal of the RoC has not reached the lower limit, the reciprocal of the RoC is decreased (step S9), and the processing is performed again from the processing of step S3.

In a case where it is determined in step S7 that the spread of the optical spectrum is not larger than the desired value, it is determined whether or not the reciprocal of the RoC has reached an upper limit (step S10). The upper limit of the reciprocal of the RoC may be, for example, (+1/distance between spatial light modulator 60 and diffraction grating 50).

In a case where it is determined in step S10 that it has reached the upper limit, it is determined whether or not the injection current is equal to or more than a threshold current (step S11). In a case where it is determined in step S11 that the injection current is equal to or more than the threshold current, the injection current is set to be equal to or less than the threshold current and the reciprocal of the RoC is set to 0 (step S12), and the processing is performed again from the processing of step S3. In a case where it is determined in step S11 that the injection current is not equal to or more than the threshold current, the processing of step S6 is performed.

In a case where it is determined in step S10 that it has not reached the upper limit, the reciprocal of the RoC is increased (step S13), and the processing is performed again from the processing of step S3.

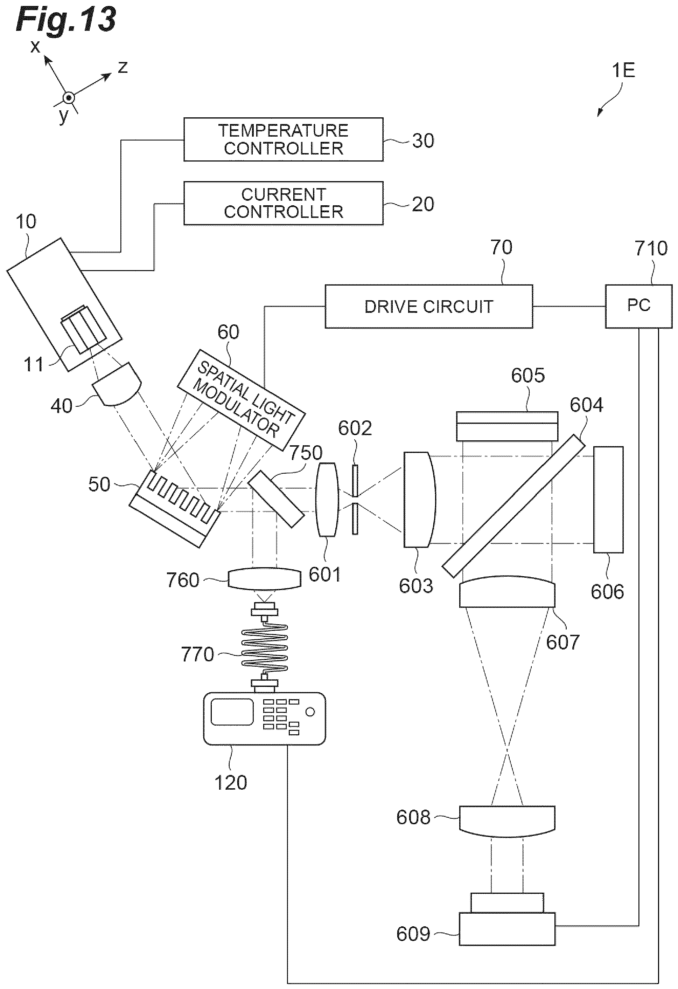

Next, a light source apparatus 1E according to a seventh embodiment will be described with reference to FIG. 13. FIG. 13 is a diagram illustrating interference measurement using the light source apparatus 1E according to the seventh embodiment. By using the light source apparatus 1E, the interference measurement can be performed similarly to the light source apparatus 1D according to the sixth embodiment described above. Here, the light source apparatus 1E is different from the light source apparatus 1D in that an optical spectrum is measured (monitored) on an output light side used for the interference measurement.

That is, the light source apparatus 1E includes a beam splitter 750, an objective lens 760, an optical fiber 770, and a spectrometer (for example, an optical spectrum analyzer) 120 as a configuration for measuring the optical spectrum. The beam splitter 750 is provided between the diffraction grating 50 and the objective lens 601. The output light from the diffraction grating 50 reaches the beam splitter 750, and is divided into light that is directly transmitted and reaches the objective lens 601 and light that is reflected and reaches the objective lens 760. The light reflected by the beam splitter 750 is coupled to the optical fiber 770 by the objective lens 760. Then, the light is input to the optical spectrum analyzer 120 via the optical fiber 770. The optical spectrum analyzer 120 measures a spectrum of the input light and outputs a measurement result to the PC 710. Then, the PC 710 generates a modulation pattern to which the measurement result in the optical spectrum analyzer 120 is fed back, and outputs the modulation pattern to the drive circuit 70. The modulation pattern to which the measurement result is fed back is displayed on the spatial light modulator 60 based on a control signal from the drive circuit 70. As described above, by measuring the optical spectrum on the output light side used for the interference measurement, feedback control of the control signal can be performed similarly to the sixth embodiment.

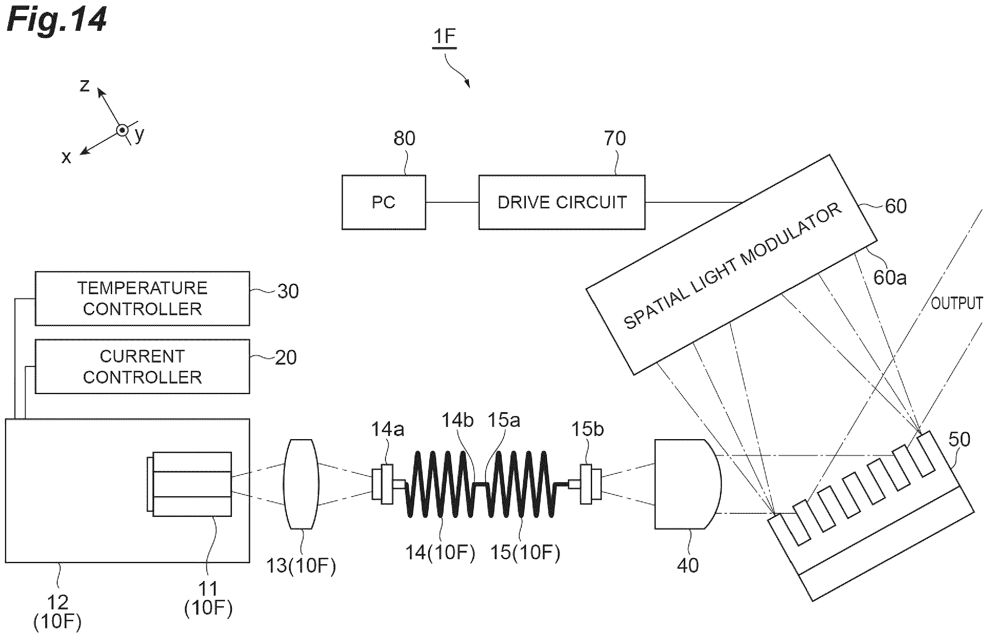

Next, a light source apparatus 1F according to an eighth embodiment will be described with reference to FIG. 14. FIG. 14 is a diagram schematically illustrating the light source apparatus 1F according to the eighth embodiment. The light source apparatus 1F illustrated in FIG. 14 is similar in basic configuration to the light source apparatus 1 according to the first embodiment, and is different from the light source apparatus 1 in including a light source unit 10F instead of the light source unit 10.

The light source unit 10F includes the light source 11 (excitation light source), the LD mount 12, a lens 13, an optical fiber 14, and a gain fiber 15. The light source 11 and the LD mount 12 have the same configurations as the light source 11 and the LD mount 12 of the light source unit 10 according to the first embodiment. The light source 11 is a light source that outputs excitation light for exciting the gain fiber 15, and is, for example, an LD. The lens 13 is a lens that focuses the excitation light output from the light source 11 on an incident end 14a of the optical fiber 14. The optical fiber 14 is an optical fiber that guides the excitation light incident from the incident end 14a to the gain fiber 15. An emission end 14b of the optical fiber 14 is coupled to an incident end 15a of the gain fiber 15. The optical fiber 14 may be, for example, a single-mode optical fiber.

The gain fiber 15 is an optical fiber amplifier having a gain corresponding to the excitation light incident from the incident end 15a via the optical fiber 14. The gain fiber 15 is, for example, a double clad fiber in which a fiber core is doped with a rare earth element. In this case, the gain fiber 15 obtains an optical gain by stimulated emission from the rare earth element. As the rare earth element, Yb (ytterbium), Er (erbium), or the like may be used. The gain fiber 15 may be a single-mode gain fiber. By using the single-mode gain fiber, nonlinearity can be enhanced and a spatial mode can be selected. The gain fiber 15 may be a highly non-linear fiber.

A fiber Bragg grating may be formed in the gain fiber 15. In addition, the gain fiber 15 and the optical fiber 14 may be coupled by another optical fiber (not illustrated), or the fiber Bragg grating may be formed in the another optical fiber. In addition, the gain fiber 15 and the optical fiber 14 may be coupled by, for example, a wavelength division multiplexing (WDM) coupler.

In the configuration including such a gain fiber 15, switching between laser oscillation and amplified spontaneous emission can be performed by adjusting power of the excitation light. In addition, in the light source unit 10F, by using the gain fiber 15 having a gain corresponding to the excitation light, light is confined in the gain fiber 15 which is a narrow space, optical power increases, and a non-linear effect is likely to occur. As the light travels back and forth many times in the optical cavity, the non-linear effect is accumulated and a larger non-linear effect can be generated. Such a non-linear effect is more likely to occur by using a highly non-linear fiber as the gain fiber 15. Examples of the non-linear effect include self-phase modulation, cross-phase modulation, modulation instability, stimulated Raman scattering, stimulated Brillouin scattering, four-wave mixing, supercontinuum generation, and the like. By using these non-linear effects, a degree of freedom of spectrum control of light is improved, for example, by further expanding the spectrum.

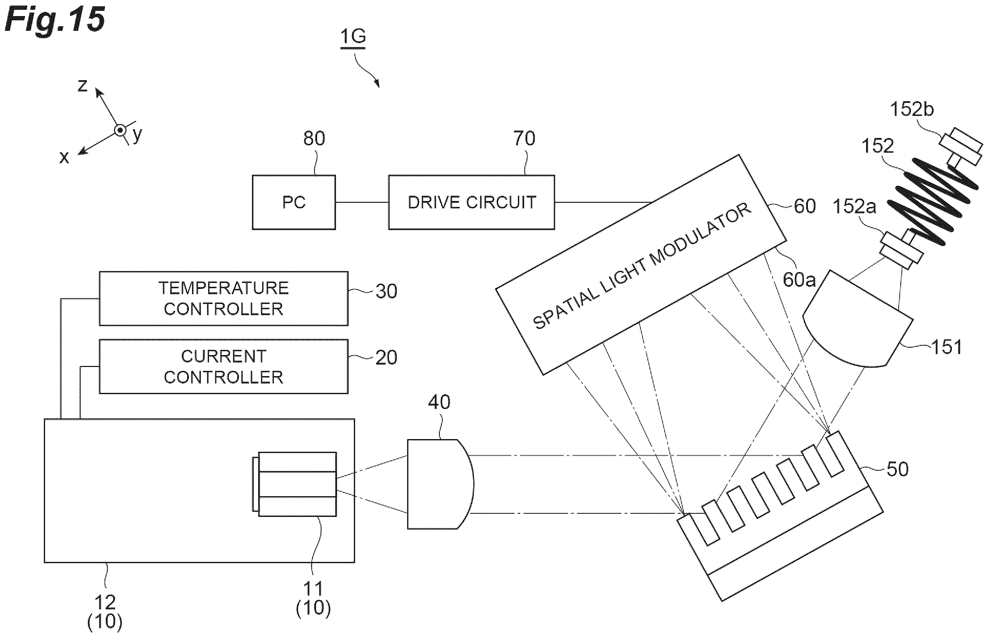

Next, a light source apparatus 1G according to a ninth embodiment will be described with reference to FIG. 15. FIG. 15 is a diagram schematically illustrating the light source apparatus 1G according to the ninth embodiment. The light source apparatus 1G illustrated in FIG. 15 is similar in basic configuration to the light source apparatus 1 according to the first embodiment, and is different from the light source apparatus 1 in including a lens 151 and an optical fiber 152. The lens 151 and the optical fiber 152 are provided in a path through which the light output from the diffraction grating 50 travels.

The lens 151 is a coupling lens for coupling the light output from the diffraction grating 50 to the optical fiber 152.

The optical fiber 152 is an optical fiber that guides the light output from the diffraction grating 50 and coupled by the lens 151. The optical fiber 152 guides light incident from an incident end 152a and emits the light from an emission end 152b. The optical fiber 152 may be a single-mode optical fiber. By using the single-mode optical fiber, nonlinearity can be enhanced and a spatial mode can be selected. In addition, the optical fiber 152 may be a highly non-linear fiber.

As described above, according to the configuration in which the light output from the diffraction grating 50 is guided by the optical fiber 152, the light is confined in the optical fiber 152, and the non-linear effect is likely to occur. In such a configuration, since the light passes through the optical fiber 152 only once, the spectrum after the non-linear effect is caused is easily predicted, and the ease of control is improved. Such a non-linear effect is more likely to occur by using a highly non-linear fiber as the optical fiber 152. By using the non-linear effect, a degree of freedom of spectrum control of light is improved, for example, by further expanding the spectrum. Note that such a configuration including an optical fiber that guides light output from the diffraction grating 50 is not limited to the aspect illustrated in FIG. 15. For example, as illustrated in FIG. 11, a configuration including the optical fiber 100 that guides light emitted from the end surface (rear end surface) of the light source 11 that is not coupled to the external cavity may be adopted. In addition, for example, a configuration including an optical fiber in which a WDM coupler or the like is inserted into a connection portion between the optical fiber 14 and the gain fiber 15 illustrated in FIG. 14, light is extracted, and the extracted light is guided may be adopted. Both configurations are common in including an optical fiber that guides light output from the diffraction grating 50.

### Reference Signs List

- 1, 1A, 1B, 1C, 1D, 1E, 1F, 1G: Light source apparatus
- 11: Light source
- 50: Diffraction grating
- 60: Spatial light modulator (reflection unit)
- 60a: Reflecting surface
- 152: Optical fiber
- 260: Variable curvature mirror
- 361: Variable focus lens
- 362: Flat mirror (mirror)

## Claims

1. A light source apparatus comprising:
a light source configured to output light;
a reflection unit having an input unit of a control signal and configured to be able to control distribution of angles at which incident light is reflected based on the control signal; and
a diffraction grating configured to disperse the light output from the light source and cause the light to be incident on the reflection unit, and return at least a part of the light reflected by the reflection unit to the light source, wherein
an optical cavity is formed by the light source and the reflection unit, and the light returned to the light source is output, and
a bandwidth of the light returned from the diffraction grating to the light source is controlled by controlling the distribution of angles of the light reflected by the reflection unit based on the control signal.

2. The light source apparatus according to claim 1, wherein
the reflection unit comprises a spatial light modulator, and
the spatial light modulator controls the distribution of angles at which the incident light is reflected by displaying a modulation pattern based on the control signal.

3. The light source apparatus according to claim 1, wherein
the reflection unit comprises a variable curvature mirror, and
the variable curvature mirror controls the distribution of angles at which the incident light is reflected by changing a radius of curvature based on the control signal.

4. The light source apparatus according to claim 1, wherein
the reflection unit comprises a mirror and a variable focus lens provided between the diffraction grating and the mirror, and
the variable focus lens controls the distribution of angles at which the incident light is reflected by changing a focal length of the variable focus lens based on the control signal.

5. The light source apparatus according to any one of claims 1 to 4, wherein
the light source outputs light according to an injection current, and
the bandwidth of the light returned from the diffraction grating to the light source is dynamically controlled by temporally changing the injection current and the control signal.

6. The light source apparatus according to any one of claims 1 to 4, wherein the reflection unit and the diffraction grating are disposed such that a curvature center related to a reflecting surface of the reflection unit coincides with a beam center of the light incident on the diffraction grating.

7. The light source apparatus according to any one of claim 1 to 4, further comprising a control signal generation unit configured to generate a second control signal based on a measurement result of the light output from the light source apparatus.

8. A control method of a light source apparatus, the control method comprising:
outputting light from a light source toward a diffraction grating; and
inputting a control signal for controlling distribution of angles of light reflected by a reflection unit where light dispersed by the diffraction grating is incident.

9. The light source apparatus according to any one of claim 1 to 4, wherein a light source unit including the light source comprises an excitation light source that outputs excitation light, and a gain fiber that is an optical fiber having a gain corresponding to the excitation light.

10. The light source apparatus according to any one of claim 1 to 4, further comprising an optical fiber configured to guide the light output from the diffraction grating.
